# EUROPÄISCHE PATENTANMELDUNG

(11) **EP 2 575 169 A2**
(43) Veröffentlichungstag der Anmeldung: **03.04.2013**
(21) Anmeldenummer: 12185297.4
(22) Anmeldetag: 20.09.2012
(51) Int. Cl.: H01L 23/495, H01L 23/48

(54) **Fügehilfe für ein Leistungsmodul**

(30) Priorität: 30.09.2011 DE 102011083906
(71) Anmelder: ROBERT BOSCH GMBH, 70442 Stuttgart (DE)
(72) Erfinder: Rittner, Martin, 71691 Freiberg (DE)

(57) **Zusammenfassung**

Die Erfindung bezieht sich auf eine Leistungsmodul mit einem Metall-Keramik-Verbundwerkstoffschicht zwischen dem Leistungshalbleiter und dem Schaltungsträger.

## Beschreibung

### Stand der Technik

Leistungsmodule, Leistungseinrichtungen sowie Verfahren zu deren Herstellung sind aus dem Stand der Technik bekannt und deren Einsatz wird inzwischen aufgrund der Energiesparpotenziale häufig als Antwort auf die globale Klimaerwärmung angesehen.

Bei konventionellen Leistungsmodulen und den darin enthaltenen Schaltungsanordnungen ist insbesondere der Unterschied der thermischen Ausdehnungskoeffizienten zwischen den einzelnen Bestandteilen des Leistungsmoduls aufgrund versagensrelevanter thermischer Spannungen im Bauteil problematisch.

### Offenbarung der Erfindung

Somit ist es eine Aufgabe der vorliegenden Erfindung, eine verbesserte Schaltungsanordnung bereitzustellen. Diese Aufgabe wird durch den Anspruch 1 der vorliegenden Erfindung gelöst. Demgemäß wird ein Schaltungsanordnung vorgeschlagen, umfassend eine Schaltungsanordnung, die mindestens einen Leistungshalbleiter sowie zumindest die metallischen Leitungsschicht eines Schaltungsträgers umfasst, wobei zwischen dem Leistungshalbleiter und dem Schaltungsträger in stoffschlüssigem Kontakt mit beiden eine Metall-Keramik-Verbundwerkstoffschicht mit einem durchgehenden Metallanteil von ≥20% angeordnet ist.

Überraschend hat sich herausgestellt, dass so die Lebensdauer und die Leistungsfähigkeit der Schaltungsanordnung bei vielen Anwendungen deutlich erhöht werden kann ohne dass die Funktionsweise der Schaltungsanordnung mehr als unwesentlich eingeschränkt wird.

Unter dem Term "Leistungshalbleiter" wird insbesondere eine halbleitender Chip verstanden, der die Aufgabe hat Ströme gleichzurichten (Diode) oder zu schalten (Transistor). Bevorzugt besteht der Leistungshalbleiter im wesentlichen aus Silizium, Siliziumcarbid oder Galliumnitrid.

Unter dem Term "Schaltungsträger" wird insbesondere ein Lagenaufbau verstanden, der aus mindestens einer metallischen Leitungsschicht und einer Isolationsschicht besteht. Bevorzugt besteht die Leitungsschicht im wesentlichen aus einem Metall wie Kupfer, Aluminium bzw. deren Mischungen oder Legierungen, die Isolationsschicht aus Keramiken oder Polymeren.

Unter dem Term "Metall-Keramik-Verbundwerkstoffschicht" wird insbesondere eine Schicht verstanden, bei der zunächst aus einem geeigneten Vorläufermaterial wie ein Pulver oder ein Grünling eine poröse Keramikschicht hergestellt wird und anschließend die Poren durch Metall infiltriert werden. Dabei kann das Metall/Keramik-Verhältnis entlang der Verbundwerkstoffschicht im wesentlichen konstant sein. Durch die Wahl des Metall/Keramik-Verhältnis kann in vorteilhafter Weise ein Ausdehnungskoeffizient der Verbundwerkstoffschicht eingestellt werden. Beispielsweise ist die Einstellung eines Ausdehnungskoeffizienten, welcher zwischen dem der jeweiligen Fügepartner liegt, bevorzugt einzustellen.

Unter dem Begriff "in stoffschlüssigem Kontakt mit beiden" wird insbesondere verstanden, dass die Metall-Keramik-Verbundwerkstoffschicht zumindest in Teilbereichen, vorzugsweise flächig abschließend sowohl mit dem Leistungshalbleiter wie dem Schaltungsträger in direktem Kontakt steht, so dass neben der mechanischen Integrität sowohl ein Wärme- wie elektrischer Ladungstransport möglich ist. Bevorzugte ist eine Ausführung der Metall-Keramik-Verbundwerkstoffschicht vorgesehen, bei welcher diese zumindest im Kontaktbereich zu einem Fügepartner eine flächige Metallisierung aufweist. Dadurch wird eine stoffschlüssige Anbindung an die Fügepartner begünstigt. Weiter bevorzugt ist die Metallisierungsschicht aus dem anteilig in der Metall-Keramik-Verbundwerkstoffschicht enthaltenen Metall ausgewählt.

Zusätzlich vorteilhaft ist das Vorsehen einer Verbindungsschicht im Kontaktbereich zwischen der Metall-Keramik-Verbundwerkstoffschicht und einem Fügepartner. Bevorzugt ist die Verbindungsschicht aus einem lötbarem, sinterbarem und/oder gesintertem Material.

Unter dem Term "durchgehender Metallanteil" wird insbesondere verstanden, dass in der Metall-Keramik-Verbundwerkstoffschicht entlang der Richtung vom Leistungshalbleiter zum Schaltungsträger der Metallanteil niemals geringer als der angegebene Prozentsatz (in Vol-% zu Vol-% der Schicht, dies gilt auch im folgenden für den gesamten Text) beträgt. Es hat sich herausgestellt, dass ein durchgehender Mindestmetallanteil von ≥20% notwendig ist, um die Funktionsweise der Schaltungsanordnung nicht zu beeinträchtigen. Bevorzugt beträgt der durchgehende Metallanteil ≥30%.

Gemäß einer bevorzugten Ausführungsform der vorliegenden Erfindung beträgt der Unterschied der thermischen Ausdehnung der Metall-Keramik-Verbundwerkstoffschicht und der thermischen Ausdehnung zumindest der Bereiche sowohl des Schaltungsträgers und des Leistungshalbleiters, die der Metall-Keramik-Verbundwerkstoffschicht zugeordnet bzw. benachbart sind, ≤14 * 10⁻⁶ /K, bevorzugt ≤12 * 10⁻⁶ /K, noch bevorzugt ≤10 * 10⁻⁶ /K, sowie am meisten bevorzugt ≤8 * 10⁻⁶ /K. Dies hat sich in der Praxis besonders bewährt, da so Leistungs- und Lebensdauerverluste, die aus den unterschiedlichen thermischen Ausdehnungskoeffizienten von Leistungshalbleiter und Schaltungsträger herrühren weitgehend vermindert oder teilweise sogar ganz vermieden werden können.

Gemäß einer bevorzugten Ausführungsform der vorliegenden Erfindung beträgt der Metallanteil in der Metall-Keramik-Verbundwerkstoffschicht (bezogen auf die gesamte Schicht) von ≥30% bis ≤70%. Dies hat sich in der Praxis als vorteilhaft herausgestellt, insbesondere in Bezug auf die Einstellung eines geeigneten Ausdehnungskoeffizienten, als auch in Bezug auf eine sehr gute elektrische und thermische Leitfähigkeit.

Je nach konkreter Ausgestaltung kann jedoch bereichsweise der Metallanteil auch höher oder geringer sein, wobei jedoch der Mindestanteil von ≥20% nicht unterschritten werden darf. Bevorzugt beträgt der Metallanteil in der Metall-Keramik-Verbundwerkstoffschicht (bezogen auf die gesamte Schicht) von ≥40% bis ≤60%, noch bevorzugt etwa 50%.

Gemäß einer bevorzugten Ausführungsform der vorliegenden Erfindung nimmt der Metallanteil der Metall-Keramik-Verbundwerkstoffschicht in Richtung des Schaltungsträgers kontinuierlich oder gestuft zu. Dies hat sich bei vielen Anwendungen als vorteilhaft herausgestellt, da auf diese Weise beispielsweise zwei Fügepartner mit unterschiedlichen Ausdehnungskoeffizienten in geeigneter Weise in Ihrem thermischen Ausdehnungsverhalten zueinander angepasst werden können. Erfindungsgemäß werden thermisch bedingte Spannungen in den Fügepartnern vermieden, zumindest deutlich reduziert.

Der Gradient kann in der Metall-Keramik-Verbundwerkstoffschicht u.a. dadurch hergestellt werden, dass beim Herstellen der Keramikschicht die Anzahl und/oder die Größe der Poren entlang der Schicht variiert wird, so dass sich beim Infiltrieren mit Metall der resultierende Metallanteil entlang der Verbundwerkstoffschicht nicht gleichförmig ist.

Gemäß einer bevorzugten Ausführungsform der vorliegenden Erfindung ist als Keramikanteil der Metall-Keramik-Verbundwerkstoffschicht Aluminiumoxid, Aluminiumnitrid, Kupfercarbid, Siliziumnitrid und/oder Siliziumcarbid vorgesehen. Derartige Materialen lassen sich in einfacher Form als Sinterformkörper herstellen, welche dann beispielsweise mit einem Metall infiltriert werden können. Denkbar sind auch davon abweichende Oxid-Keramiken oder Nicht-Oxid-Keramiken auf Basis von Carbiden, Nitriden oder Boriden.

Gemäß einer bevorzugten Ausführungsform der vorliegenden Erfindung ist als Metallanteil der Metall-Keramik-Verbundwerkstoffschicht Silber, Kupfer, Aluminium bzw. deren Mischungen und Legierungen vorgesehen. Derartige Materialien lassen sich leicht verarbeiten und sind insbesondere auch zum Infiltrieren in vorbereitete Sinterformkörper zum Ausbilden einer Metall-Keramik-Verbundwerkstoffschicht geeignet.

Die vorliegende Erfindung bezieht sich außerdem auf einen Schichtverbund zum Verbinden von elektronischen und/oder elektrischen Bauteilen als Fügepartner, umfassend mindestens eine Trägerfolie und eine darauf angeordnete Schichtanordnung umfassend eine Metall-Keramik-Verbundwerkstoffschicht, sowie eine auf der Metall-Keramik-Verbundwerkstoffschicht angeordnete Metallisierungsschicht und/oder Verbindungsschicht. In Bezug auf die Ausführung der Metall-Keramik-Verbundwerkstoffschicht, der Metallisierung und der Verbindungsschicht sei auf die entsprechende Ausführungen bei der erfindungsgemäßen Schaltungsanordnung verwiesen. Die Trägerfolie ist bevorzugt klebend haftend zur Schichtanordnung ausgeführt und dient in erster Linie als Transport- und Handlingshilfe sowie als Schutz für die Schichtanordnung gegen Verschmutzung. Die Trägerfolie kann einseitig oder beidseitig auf der Schichtanordnung haftend vorgesehen sein. Bei der Herstellung beispielsweise einer erfindungsgemäßen Schaltungsanordnung lässt sich die Schichtanordnung von der Trägerfolie in einfacher Weise lösen. Daraufhin kann die Schichtanordnung zum Verbinden von elektronischen und/oder elektrischen Bauteilen als Fügepartner zwischen diesen angeordnet werden, In vorteilhafter Weise kann der erfindungsgemäße Schichtverbund als Verbindungselement wie ein elektronisches oder elektrisches Bauelement im Fertigungsprozess eingesetzt werden.

In einer vorteilhaften Ausführungsform sind auf der Trägerfolie, insbesondere bereichsweise beabstandet, eine Vielzahl einzelner Fügeformteile aus der Schichtanordnung haftend angeordnet. Ein auf diese Weise ausgeführter Schichtverbund ist besonders geeignet für den Einsatz in einer automatischen Fertigungslinie zur Herstellung von Schaltungsanordnungen.

Darüber hinaus kann ein erfindungsgemäßer Schichtverbund weitere Keramik-, Metall- oder Metall-Keramik-Verbundwerkstoffschichten enthalten. Besonders bevorzugt ist ein Ausführung, bei welcher beidseitig an die Metall-Keramik-Verbundwerstoffschicht eine Metallisierungsschicht und/oder eine Verbindungsschicht vorgesehen sind.

Die vorliegende Erfindung bezieht sich außerdem auf ein Leistungsmodul, umfassend eine erfindungsgemäße Schaltungsanordnung und/oder einen erfindungsgemäßen Schichtverbund.

Unter dem Term "Leistungsmodul" wird insbesondere ein Schaltungsträger mit darauf gefügten Leistungshalbleitern und einem Gehäuse verstanden. Bevorzugt ist das Gehäuse aus einem Metall oder aus einer den Schaltungsträger und/oder den Leistungshalbleiter zumindest bereichsweise umschließenden Moldmasse gebildet.

Die Metall-Keramik-Verbundwerkstoffschicht kann mit dem Leistungshalbleiter und/oder dem Schaltungsträger auf folgende Weise verbunden bzw. auf diesen aufgebracht werden: Weich- und Hartlöten, Diffusionslöten, Sintern, Bonden, Schweißen, Infiltrieren.

Insbesondere wird ein Verfahren zum Herstellen einer erfindungsgemäßen Schaltungsanordnung bereitgestellt, umfassend die Schritte:
- Bereitstellen der metallischen Leitungsschicht eines Schaltungsträgers (30),
- Bereitstellen mindestens eines Leistungshalbleiters (20),
- Bereitstellen einer keramischen Preform, sowie
- Infiltrieren der keramischen Preform mit Metall, um eine Metall-Keramik-Verbundwerkstoffschicht (10) so herzustellen, dass sich ein durchgehender Mindestmetallanteil von ≥20% ergibt,
- Zusammenfügen des Schaltungsträgers (30), des Leistungshalbleiters (20) und der Metall-Keramik-Verbundwerkstoffschicht (10), derart, dass die Metall-Keramik-Verbundwerkstoffschicht (10) zwischen dem Leistungshalbleiter (20) und dem Schaltungsträger (30) in stoffschlüssigem Kontakt steht.

Zur Verbesserung der stoffschlüssigen Kontaktes kann die Metall-Keramik-Verbundwerkstoffschicht im Kontaktbereich zu einem Fügepartner, zum Beispiel zu dem Leistungshalbleiter bzw. zu dem Schaltungsträger, mit einer Metallisierung versehen werden. Außerdem kann zwischen der Metall-Keramik-Verbundwerkstoffschicht und einem der Fügepartner zur Ausbildung eines stoffschlüssigen Kontaktes eine Verbindungsschicht aufgetragen werden, insbesondere eine lötbare, sinterbare und/oder gesinterte Verbindungsschicht. Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in denen - beispielhaft - mehrere Ausführungsbeispiele des erfindungsgemäßen Leistungsmoduls dargestellt sind. In den Zeichnungen zeigt:
Fig. 1 eine schematische ausschnittsweise Schnittansicht eines Leistungsmoduls mit einer Schaltungsanordnung gemäß einer ersten Ausführungsform der Erfindung.
Fig. 2 eine schematische ausschnittsweise Schnittansicht eines Leistungsmoduls gemäß einer zweiten Ausführungsform der Erfindung.

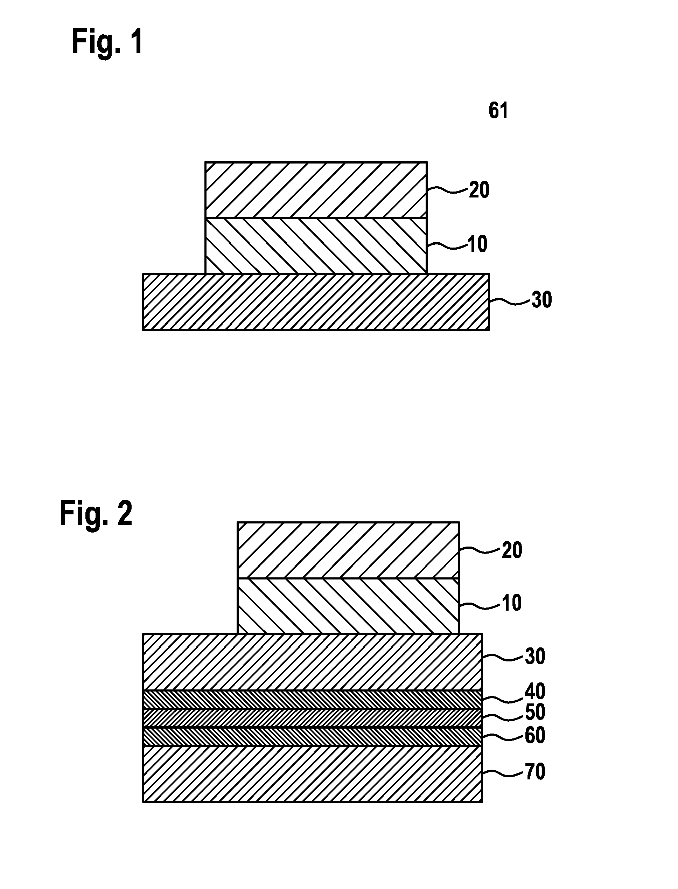

Fig.1 zeigt eine schematische ausschnittsweise Schnittansicht eines Leistungsmoduls 1. Das Leistungsmodul umfasst eine Schaltungsanordnung gemäß einer ersten Ausführungsform der Erfindung bestehend aus einem Leistungshalbleiter 20 sowie einem Stanzgitter 30, welches den Schaltungsträger darstellt. Zwischen dem Leistungshalbleiter 20 und dem Stanzgitter/Schaltungsträger 30 ist die Metall-Keramik-Verbundwerkstoffschicht 10 so angeordnet, dass diese im stoffschlüssigem Kontakt sowohl zum Leistungshalbleiter 20 und Schaltungsträger 30 besitzt. Dies führt dazu, dass sich bei Betrieb der Schaltungsanordnung sowohl die thermomechanischen Unterschiede, die sich aus den unterschiedlichen Materialien des Leistungshalbleiters 20 (Halbleitermaterial wie Silizium etc.) wie des Schaltungsträgers 30 (welcher im wesentlichen aus Metall besteht) weitgehend ausgleichen bzw. zu keinen oder nur unwesentlichen Lebensdauer- wie Effizienzverlusten des Leistungsmoduls 1 führen.

Fig. 2 eine schematische ausschnittsweise Schnittansicht eines Leistungsmoduls gemäß einer zweiten Ausführungsform der Erfindung. Bauteile, die mit dem Leistungsmodul aus Fig. 1 identisch sind, sind mit denselben Bezugszeichen versehen und werden nicht erneut diskutiert.

Das Leistungsmodul aus Fig. 2 unterscheidet sich von dem aus Fig. 1 dadurch, dass ein Schaltungsträger ausgebildet ist, bei dem weitere MMC Metall und Keramikschichten vorgesehen sind. Konkret sind dies eine Zwischenschicht 40 aus einer Metall-Keramik-Verbundwerkstoffschicht, eine Keramikschicht 50, eine weitere Zwischenschicht 60 aus einer Metall-Keramik-Verbundwerkstoffschicht sowie eine Metallschicht 70.

Die einzelnen Kombinationen der Bestandteile und der Merkmale von den bereits erwähnten Ausführungen sind exemplarisch; der Austausch und die Substitution dieser Lehren mit anderen Lehren, die in dieser Druckschrift enthalten sind mit den zitierten Druckschriften werden ebenfalls ausdrücklich erwogen. Der Fachmann erkennt, dass Variationen, Modifikationen und andere Ausführungen, die hier beschrieben werden, ebenfalls auftreten können ohne von dem Erfindungsgedanken und dem Umfang der Erfindung abzuweichen. Entsprechend ist die obengenannte Beschreibung beispielhaft und nicht als beschränkend anzusehen. Das in den Ansprüchen verwendetet Wort umfassen schließt nicht andere Bestandteile oder Schritte aus. Der unbestimmte Artikel "ein" schließt nicht die Bedeutung eines Plurals aus. Die bloße Tatsache, dass bestimmte Maße in gegenseitig verschiedenen Ansprüchen rezitiert werden, verdeutlicht nicht, dass eine Kombination von diesen Maßen nicht zum Vorteil benutzt werde kann. Der Umfang der Erfindung ist in den folgenden Ansprüchen definiert und den dazugehörigen Äquivalenten.

## Patentansprüche

1. Schaltungsanordnung, die mindestens einen Leistungshalbleiter (20) sowie zumindest die metallische Leitungsschicht eines Schaltungsträgers (30) umfasst, **dadurch gekennzeichnet, dass** zwischen dem Leistungshalbleiter (20) und dem Schaltungsträger (30) in stoffschlüssigem Kontakt mit beiden eine Metall-Keramik-Verbundwerkstoffschicht (10) mit einem durchgehenden Metallanteil von ≥20% angeordnet ist.

2. Schaltungsanordnung nach Anspruch 1, **dadurch gekennzeichnet, dass** der durchgehende Metallanteil ≥30% beträgt.

3. Schaltungsanordnung nach einem der vorhergehenden Ansprüche,
**dadurch gekennzeichnet, dass** der Unterschied der thermischen Ausdehnung der Metall-Keramik-Verbundwerkstoffschicht (10) und der thermischen Ausdehnung zumindest der Bereiche sowohl des Schaltungsträgers (30) und des Leistungshalbleiters (20), die der Metall-Keramik-Verbundwerkstoffschicht (10) zugeordnet bzw. benachbart sind, ≤14 * 10⁻⁶ /K beträgt.

4. Schaltungsanordnung nach einem der vorhergehenden Ansprüche,
**dadurch gekennzeichnet, dass** der Metallanteil in der Metall-Keramik-Verbundwerkstoffschicht von ≥30% bis ≤70% beträgt.

5. Schaltungsanordnung nach einem der vorhergehenden Ansprüche,
**dadurch gekennzeichnet, dass** der Metallanteil in der Metall-Keramik-Verbundwerkstoffschicht (10) von ≥40% bis ≤60% beträgt

6. Schaltungsanordnung nach einem der vorhergehenden Ansprüche,
**dadurch gekennzeichnet, dass** der Metallanteil der Metall-Keramik-Verbundwerkstoffschicht (10) in Richtung des Schaltungsträgers kontinuierlich oder gestuft zunimmt.

7. Schaltungsanordnung nach einem der vorhergehenden Ansprüche,
**dadurch gekennzeichnet, dass** als Keramikanteil der Metall-Keramik-Verbundwerkstoffschicht (10) Aluminiumoxid, Aluminiumnitrid, Kupfercarbid, Siliziumnitrid und/oder Siliziumcarbid vorgesehen ist.

8. Schaltungsanordnung nach einem der vorhergehenden Ansprüche,
**dadurch gekennzeichnet, dass** als Metallanteil der Metall-Keramik-Verbundwerkstoffschicht (10) Silber, Kupfer, Aluminium bzw. deren Mischungen und Legierungen vorgesehen ist.

9. Schaltungsanordnung nach einem der vorhergehenden Ansprüche,
**dadurch gekennzeichnet, dass** auf der Metall-Keramik-Verbundwerkstoffschicht (10) eine Metallisierungsschicht und/oder eine Verbindungsschicht vorgesehen ist.

10. Schaltungsanordnung nach Anspruch 9, **dadurch gekennzeichnet, dass** die Metallisierungsschicht aus dem anteilig in der Metall-Keramik-Verbundwerkstoffschicht (10) enthaltenem Metall und die Verbindungsschicht aus einem lötbarem, sinterbarem und/oder gesintertem Material vorgesehen ist.

11. Schichtverbund zum Verbinden von elektronischen und/oder elektrischen Bauteilen als Fügepartner, umfassend mindestens eine Trägerfolie und eine darauf angeordnete Schichtanordnung, **dadurch gekennzeichnet, dass** die Schichtanordnung eine Metall-Keramik-Verbundwerkstoffschicht, sowie eine auf der Metall-Keramik-Verbundwerkstoffschicht angeordnete Metallisierungsschicht und/oder Verbindungsschicht umfasst.

12. Schichtverbund nach Anspruch 11, **dadurch gekennzeichnet, dass** auf der Trägerfolie, insbesondere bereichsweise beabstandet, eine Vielzahl einzelner Fügeformteile aus der Schichtanordnung haftend angeordnet sind.

13. Schichtverbund nach einem der Ansprüche 11 oder 12, **dadurch gekennzeichnet, dass** die Schichtanordnung weitere Keramik-, Metall- oder Metall-Keramik-Verbundwerkstoffschichten umfasst.

14. Leistungsmodul **dadurch gekennzeichnet, dass** es eine Schaltungsanordnung gemäß Anspruch 1 bis 10 umfasst.

15. Verfahren zur Herstellung einer Schaltungsanordnung gemäß einem den Ansprüche 1 bis 8, umfassend die Schritte:
- Bereitstellen der metallischen Leitungsschicht eines Schaltungsträgers (30),
- Bereitstellen mindestens eines Leistungshalbleiters (20),
- Bereitstellen einer keramischen Preform, sowie
- Infiltrieren der keramischen Preform mit Metall, um eine Metall-Keramik-Verbundwerkstoffschicht (10) so herzustellen, dass sich ein durchgehender Mindestmetallanteil von ≥20% ergibt,
- Zusammenfügen des Schaltungsträgers (30), des Leistungshalbleiters (20) und der Metall-Keramik-Verbundwerkstoffschicht (10), derart, dass die Metall-Keramik-Verbundwerkstoffschicht (10) zwischen dem Leistungshalbleiter (20) und dem Schaltungsträger (30) in stoffschlüssigem Kontakt steht.
